Europäisches Patentamt

European Patent Office

Office européen des brevets

(19)

(11) Veröffentlichungsnummer: **0 062 081**
**B1**

(12) # EUROPÄISCHE PATENTSCHRIFT

(45) Veröffentlichungstag der Patentschrift:
20.03.85

(51) Int. Cl.⁴: **H 03 M 1/36**

(21) Anmeldenummer: 81102538.6

(22) Anmeldetag: 03.04.81

(54) **Parallel-Analog-Digital-Wandler.**

(43) Veröffentlichungstag der Anmeldung:
13.10.82 Patentblatt 82/41

(45) Bekanntmachung des Hinweises auf die Patenterteilung:
20.03.85 Patentblatt 85/12

(84) Benannte Vertragsstaaten:
DE FR GB IT NL

(56) Entgegenhaltungen:
FR - A - 2 232 881
GB - A - 2 004 150
US - A - 3 662 380
US - A - 3 949 170

PATENT ABSTRACTS OF JAPAN, Band 3, Nr. 56, 15. Mai
1979, Seiten 52E110

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Höhn, Wolfgang, Dipl.-Ing., Keltenring 35,
D-7815 Kirchzarten (DE)**

(74) Vertreter: **Stutzer, Gerhard, Dr., Deutsche ITT Industries
GmbH Patent- und Lizenzabteilung
Hans-Bunte-Strasse 19 Postfach 840, D-7800 Freiburg
(DE)**

## Beschreibung

Die Erfindung bezieht sich auf Parallel-Analog-Digital-Wandler mit $p = 2^r-1$ Komparatoren, wobei r die um eins verminderte Anzahl der Binärstellen seines Ausgangssignals ist und wobei das Analogsignal den Komparatoreingängen der einen Art zugeführt ist und die Eingänge der anderen Art aufeinanderfolgend an den Abgriffen eines ohmschen Spannungsteilers mit untereinander gleichen Widerständen liegen, dem eine Referenzspannung Ur zugeführt ist, und wobei für die Dauer jeder zweiten Taktperiode des Wandler-Abtastsignals das Analogsignal um $\triangle U = Ur/2^{r+1}$ verschoben wird, vgl. den Oberbegriff des Anspruchs 1.

Ein derartiger Parallel-Analog-Digital-Wandler ist bereits in der älteren europäischen Anmeldung Nr. 0 038 464 mit dem Titel «Farbfernseh-Empfänger mit mindestens einer integrierten Schaltung zur Trennung und Aufbereitung des Luminanzsignals und der Chrominanzsignale aus dem Farb-Bild-Austast-Synchron-Signalgemisch», mit der die Priorität der DE-Patentanmeldung P 30 15 141.8 beansprucht ist, vorgeschlagen worden, und zwar als eine der beiden Möglichkeiten für die Reduzierung der Anzahl der Komparatoren und Widerstände des an der Referenzspannung liegenden Spannungsteilers. In der älteren Anmeldung ist ausführlich beschrieben, wie die Spannungsänderung $\triangle U$ durch Beschaltung des Spannungsteilers erreicht wird, während die Realisierungsmöglichkeit für die entsprechende Umschaltung der mit dem Analogsignal gespeisten Komparatoreingänge offengelassen ist. Dieses Dokument fällt unter Art. 54(3) EPÜ.

Aus der GB-A-2 004 150 ist es bei einem Parallel-Analog-Digital-Wandler mit Halbschrittumschaltung, die allerdings während jeder Hälfte der Taktperiode erfolgt, bekannt, die niederstwertige Stelle am Ausgang des Digitalcodierers und die entsprechende am Ausgang des Pufferspeichers über ein Exklusiv-ODER-Gatter miteinander zu verknüpfen, an dessen Ausgang die niederstwertige Stelle des Ausgangssignals des Parallel-Analog-Digital-Wandlers auftritt. Auch in diesem Stand der Technik ist offengelassen, wie die Umschaltung schaltungstechnisch zu realisieren ist.

Der in den Ansprüchen gekennzeichneten Erfindung liegt die Aufgabe zugrunde, eine konkrete schaltungstechnische Lösung für die Umschaltung des Gleichspannungspegels an den mit dem Analogsignal gespeisten Komparatoreingängen anzugeben.

Ein Vorteil der Erfindung ist darin zu sehen, dass für die im allgemeinen erforderlichen Spannungsänderungen $\triangle U$ im Millivoltbereich (z.B. bei einem erfindungsgemässen Wandler mit sechsstelligem Ausgangssignal) der Widerstand R niederohmig sein kann (z.B. $\triangle U = 10$ mV, $R = 10\Omega$, $I = 1$ mA) und somit bei der monolithischen Integrierung leicht realisiert werden kann. Ein weiterer Vorteil der Erfindung besteht darin, dass aufgrund dieser Niederohmigkeit keine Begrenzung hinsichtlich des Frequenzverhaltens des Wandlers auftritt.

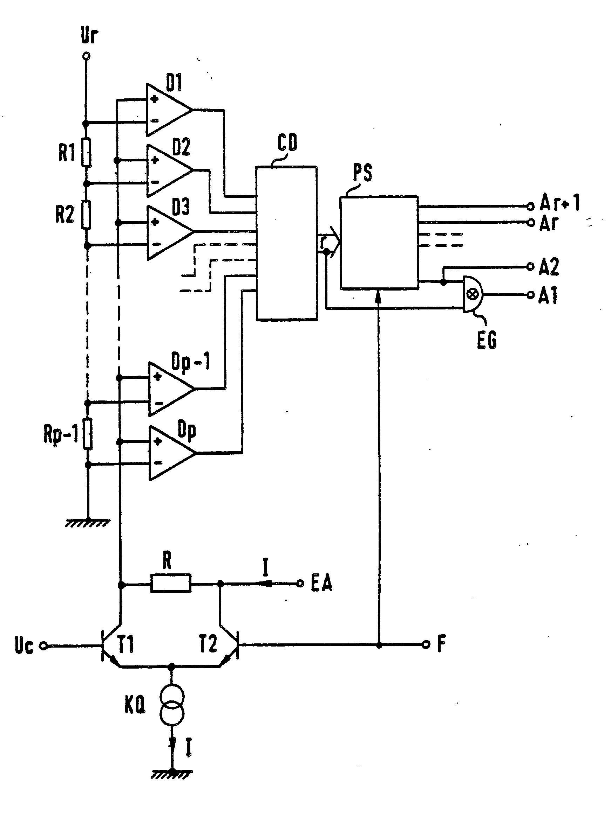

Die Erfindung wird nun anhand des in der Figur der Zeichnung dargestellten, teilweise schematischen Schaltbilds eines Ausführungsbeispiels näher erläutert.

Der Parallel-Analog-Digital-Wandler enthält die Komparatoren D1, D2, D3, D(p-1), Dp, die vorzugsweise als Differenzverstärker ausgebildet sind. Die invertierenden Eingänge der Komparatoren liegen an den Abgriffen des aus den Widerständen R1, R2, R(p-1) gleichen Widerstandswertes gebildeten Spannungsteilers, dessen einem Ende die Referenzspannung Ur zugeführt ist und dessen anderes Ende mit dem Schaltungsnullpunkt verbunden ist.

Die nichtinvertierenden Eingänge der Komparatoren liegen gemeinsam über den Widerstand R am Eingang EA für das zu wandelnde Analogsignal. Der Widerstand R verbindet die Kollektoren der beiden Transistoren T1, T2, deren Emitter miteinander verbunden und über die den Strom I liefernde Konstandstromquelle KQ mit dem Schaltungsnullpunkt verbunden sind. In der Figur liegt somit der Kollektor des Transistors T1 an den zusammengeschalteten nichtinvertierenden Eingängen der Komparatoren D1... Dp, während der Kollektor des Transistors T2 mit dem Analogsignal-Eingang EA verbunden ist.

Die Basis des einen der beiden Transistoren T1, T2 liegt auf dem konstanten Potential $U_c$ — in der Figur ist das der Transistor T1 —, während der Basis des anderen Transistors — in der Figur Transistor T2 — das Taktsignal F mit der halben Frequenz des Wandler-Taktsignals zugeführt ist.

Die Ausgänge der Komparatoren D1...Dp sind mit den Eingängen des Codierers CD verbunden, an dessen Ausgang in üblicher Weise ein r-stelliges Binärsignal entsteht. Dieses Binärsignal wird im Pufferspeicher PS gespeichert, der vom Taktsignal F getaktet ist. Die niederstwertige Stelle des Codierer-Ausgangssignals und die niederstwertige Stelle des Pufferspeicher-Ausgangssignals sind den beiden Eingängen des Exklusiv-ODER-Gatters EG zugeführt, an dessen Ausgang die niederstwertige Stelle A1 des Wandler-Ausgangssignals entsteht; am Ausgang der niederstwertigen Stelle des Pufferspeichers PS entsteht dann die zweitniederste Stelle A2 des Wandler-Ausgangssignals. Entsprechend ist die höchstwertige Stelle des Pufferspeicher-Ausgangssignals die höchstwertige Stelle A(r + 1) des Wandler-Ausgangssignals.

Bei der Erfindung ist es somit ebenso wie bei der älteren Anordnung möglich, mit $2^r-1$ Komparatoren, die eigentlich nur ein r-stelliges Digitalsignal erzeugen, ein (r + 1)-stelliges Wandler-Ausgangssignal zu erzeugen.

Im einzelnen geschieht das so, dass das während einer bestimmten Periode des Wandlers-Taktsignals am Ausgang des Codierers CD auftretende Digitalsignal im Pufferspeicher PS bis in die nächste Wandler-Taktsignal-Periode gespeichert wird und gegen Ende dieser Periode mit dem dann am Ausgang des Codierers CD neuen Digitalsignal im Exklusiv-ODER-Gatter EG bezüglich der niederstwertigen Stelle verknüpft wird. Da in der betrachteten zweiten Wandler-Taktsignal-Periode die Umschaltung der nichtinvertierenden Komparatoreingänge um $\triangle U = Ur/2^{r+1}$ erfolgt, ergibt sich durch diesen Verknüpfungsschritt am Ende jeder zweiten Periode des Wandler-Taktsignals der Gewinn einer zusätzlichen Wandler-Ausgangssignal-Stelle.

Der Wert des Widerstands R ergibt sich daraus, dass der Strom I der Konstantstromquelle KQ, dessen Stromkreis sich über den das Analogsignal an den Analogsignal-Eingang EA liefernden Schaltungsteil schliesst, während des einen Teils des z.B. rechteckförmigen Taktsignals F über den Transistor T2 und somit nicht durch den Widerstand R und während des anderen Teils über den Transistor T1 und somit über den Widerstand R fliesst. Also ergibt sich für die Bemessung des Widerstands R folgende Bemessungsregel: $R = \triangle U/I = 2^{-(r+1)}Ur/I$. Es ist klar, dass die Amplitude des Taktsignals F bezüglich der konstanten Spannung Uc so zu wählen ist, dass während der erwähnten beiden Teile des Taktsignals F die abwechselnde Leitendsteuerung bzw. Sperrung der beiden Transistoren T1, T2 ermöglicht wird.

Die Erfindung eignet sich insbesondere für schnelle Parallel-Analog-Digital-Wandler, z.B. für Videosignale, und erlaubt die Erzeugung eines z.B. sechsstelligen Wandler-Ausgangssignals mit einer Anzahl an Komparatoren, die der Hälfte derjenigen Komparatoranzahl ohne Eingangsspannungsänderung $\triangle U$ entspricht.

## Patentansprüche

1. Parallel-Analog-Digital-Wandler mit $p = 2^r\text{-}1$ Komparatoren (D1...Dp), wobei r die um eins verminderte Anzahl seines (r + 1)-stelligen Ausgangssignals (A1...A(r + 1)) ist und den nichtinvertierenden (oder invertierenden) Eingängen der p Komparatoren (D1 ...Dp) gemeinsam das Ausgangssignal zugeführt ist und deren invertierende (oder nichtinvertierende) Eingänge aufeinanderfolgend an den Abgriffen eines ohmschen Spannungsteilers (R1...R(p-1)) angeschlossen sind, der untereinander gleiche Widerstände enthält und dem eine Referenzspannung (Ur) zugeführt ist, und wobei für die Dauer jeder zweiten Taktperiode des Wandler-Taktsignals das Analogsignal um $\triangle U = Ur/2^{r+1}$ verschoben wird und den Komparatorausgängen ein Digitalcodierer (CD) und diesem ein Pufferspeicher (PS) nachgeschaltet ist, gekennzeichnet durch folgende Merkmale:

— das Analogsignal ist den entsprechenden Komparatoreingängen über einen Widerstand (R) zugeführt, der die Kollektoren zweier differenzverstärkerartig mit Emitterkreis-Konstantstromquelle (KQ) geschalteten Transistoren (T1, T2) verbindet, wobei die Basis des einen Transistors auf konstantem Potential (Uc) liegt und der des anderen ein Taktsignal (F) mit der halben Wandler-Taktsignal-Frequenz zugeführt ist,

— der Wert des Widerstands (R) ist nach folgender Gleichung zu bemessen: $R = \triangle U/I = 2^{-(r+1)}Ur/I$, wobei I die Stärke des Konstantstromquellenstroms ist, und

— die niederstwertige Stelle am Ausgang des Digitalcodierers (CD) und die entsprechende am Ausgang des Pufferspeichers (PS) sind über ein Exklusiv-ODER-Gatter (EG) miteinander verknüpft, an dessen Ausgang die niederstwertige Stelle (A1) des Ausgangssignals (Ar...A(r + 1)) des Parallel-Digital-Wandlers auftritt.

2. Wandler nach Anspruch 1, dadurch gekennzeichnet, dass die differenzverstärkerartig mit Emitterkreis-Konstantstromquelle (KQ) geschalteten Transistoren (T1, T2) Bipolar-Transistoren sind.

## Claims

1. Parallel analog-to-digital converter with $p = 2^r\text{-}1$ comparators (D1 to Dp) where r is the number of bits of the (r + 1)-bit converter output signal (A1 to A(r + 1)) diminished by 1, wherein the analog signal is applied to the noninverting (or inverting) inputs of all p comparators (D1 to Dp), whose inverting (or noninverting) inputs are connected consecutively to the taps of a resistive voltage divider (R1 to R(p-1)) consisting of equal-value resistors and having a reference voltage (Ur) applied thereto, wherein the analog signal is shifted by $\triangle U = Ur/2^{r+1}$ for the duration of every second clock period of the converter clock signal, and wherein the comparator outputs are connected to a digital encoder (CD) followed by a buffer memory (PS), characterized by the following features:

— the analog signal is applied to the appropriate comparator inputs through a resistor (R) interconnecting the collectors of two transistors (T1, T2) connected in the manner of a differential amplifier and having a constant-current source (KQ) in the emitter circuit, the base of one of the transistors being at fixed potential (Uc), and the base of the other transistor being fed with a clock signal (F) of half the frequency of the converter clock signal;

— the value of the resistor (R) is chosen according to the following equation: $R = \triangle U/I = 2^{-(r+1)}Ur/I$, where I is the strenght of the constant-current-source current, and

— the least significant bit at the output of the digital encoder (CD) and the corresponding bit at the output of the buffer memory (PS) are combined via an exclusive-OR gate (EG) whose output provides the least significant bit (A1) of the output signal (Ar to A(r + 1)) of the parallel analog-to-digital converter.

2. A converter as claimed in claim 1, characterized in that the transistors (T1, T2) connected in the manner of a differential amplifier and having a constant-current source (KQ) in the emitter circuit are bipolar transistors.

## Revendications

1. Convertisseur analogique-numérique parallèle, comportant $p = 2^r\text{-}1$ comparateurs (D1...Dp), r étant le nombre diminué de un, des chiffres binaires de son signal de sortie (A1...A(r + 1)) à (r + 1) chiffres, et le signal analogique étant amené en commun aux entrées non-inverseuses (ou inverseuses) des p comparateurs (D1...Dp) dont les entrées inverseuses sont connectées consécutivement aux prises d'un diviseur de tension ohmique TR1...R(p-1)) comportant des résistances égales les unes aux autres, une tension de référence (Ur) étant appliquée à ce diviseur de tension, et le signal analogique étant décalé de $\triangle U = Ur/2^{r+1}$ pendant la durée d'une période sur deux du signal d'horloge du convertisseur, les sorties des comparateurs étant suivies d'un codeur numérique (CD), lui-même suivi d'une méroire tampon (PS), caractérisé par les particularités suivantes:

— le signal analogique est amené aux entrées de comparateurs appropriées par l'intermédiaire d'une résistance (R) qui relie les collecteurs de deux transistors (T1, T2) branchés à la façon d'un amplificateur différentiel avec une source de courant constant (KQ) dans leurs circuits d'émetteurs, la base du premier transistor étant à un potentiel constant (Uc) et celle de l'autre recevant un signal d'horloge (F) ayant une fréquence qui est la moitié de celle du signal d'horloge du convertisseur,

— la valeur de la résistance (R) est dimensionnée selon l'égalité suivante: $R = \triangle U/I = 2^{-(r+1)}Ur/I$, I étant l'intensité du courant de la source de courant constant, et

— le chiffre de plus faible rang à la sortie du codeur numérique (CD) et le chiffre correspondant à la sortie de la mémoire tampon (PS) sont combinés l'un avec l'autre par une porte OU-exclusif (EG) à la sortie de laquelle est fourni le chiffre de plus faible rang (A1) du signal de sortie $(Ar...A(r+1))$ du convertisseur analogique-numérique parallèle.

2. Convertisseur selon la revendication 1, caractérisé en ce que les transistors (T1, T2) branchés à la façon d'un amplificateur différentiel à source de courant constant (KQ) dans leur circuit d'émetteurs sont des transistors bipolaires.